# FASCICULE DE BREVET EUROPEEN

(11) **EP 2 015 085 B1**
(45) Date de publication et mention de la délivrance du brevet: **06.01.2010**
(21) Numéro de dépôt: 08012391.2
(22) Date de dépôt: 09.07.2008
(51) Int. Cl.: G01R 31/00, G01R 31/317

(54) **Procédé de test d'un système électronique**
Verfahren zum testen eines elektronischen Systems
Method of testing an electronic system

(30) Priorité: 13.07.2007 FR 0705084
(43) Date de publication de la demande: 14.01.2009
(73) Titulaire: EUROCOPTER, 13725 Marignane Cédex (FR)
(72) Inventeur: Cahon, Gilles, 13880 Velaux (FR); Gaurel, Christian, 13012 Marseille (FR)
(74) Mandataire: GPI & Associés

(56) Documents cités:
- EP-B1- 0 827 608
- US-B1- 7 240 303
- AMLA N ET AL: "Using Z specifications in category partition testing" PROCEEDINGS OF THE ANNUAL CONFERENCE ON COMPUTER ASSURANCE (COMPASS). GAITHERSBURG, JUNE 15 - 18, 1992, NEW YORK, IEEE, US, vol. CONF. 7, 15 juin 1992 (1992-06-15), pages 3-10, XP010060440 ISBN: 0-7803-0579-5

## Description

La présente invention est relative à un système et à un procédé de test d'un système électronique.

Le domaine technique de l'invention est celui de la fabrication d'hélicoptères.

La présente invention est en particulier relative à un système de test d'un système électronique comportant plusieurs équipements électroniques et une ou plusieurs structure(s) d'interconnexion reliant ces équipements.

L'invention s'applique notamment au cas où l'interconnexion est réalisée par un ou plusieurs bus/liaison(s) de communication qui est(sont) conforme(s) à une ou plusieurs normes choisies parmi les normes MIL-STD-1553 (A ou B), STANAG 3350, STANAG 3838, STANAG 3910, ARINC 429, ARINC 453, ARINC 629, ARINC 636, MIL-STD-1773, AFDX, ASCB, CSDB, IEEE P1014, RS232, RS422, RS485.

Les systèmes électroniques embarqués à bord d'avions ou giravions comportent généralement plusieurs calculateurs reliés à des capteurs, à des actionneurs, et à des afficheurs notamment.

Les tests de bon fonctionnement de tels systèmes sont complexes, longs, et par conséquent coûteux.

La préparation et la réalisation de ces tests sont rendues difficile du fait, notamment, du grand nombre de signaux et données échangés par les équipements lors de leur fonctionnement, et du grand nombre de configurations possibles des équipements constituant ce système électronique selon, par exemple, que le système électronique est prévu pour équiper un aéronef dénué de système d'arme ou au contraire pour équiper un aéronef doté d'un système d'arme.

Le brevet EP-532017 décrit un système de test d'un équipement électronique qui comporte un contrôleur d'essais générique GTC ainsi qu'une unité d'interface fonctionnelle FIU - spécifique à un système d'arme particulier - qui sont chacun reliés à un panneau d'interface avec les appareils en cours de test et qui communiquent par l'intermédiaire d'un bus IEEE-488. Le contrôleur génétique GTC et l'unité spécifique FIU sont chacun reliés à des cartes - ou instruments - d'entrée/sortie analogique et numérique, par l'intermédiaire d'un bus IEEE-796. Le contrôleur GTC comporte des cartes d'interface avec le bus 1553 qui peuvent fonctionner comme contrôleur de bus, comme terminal, ou comme moniteur de bus. Des programmes de test peuvent être modifiés et compilés par un ordinateur central, par l'intermédiaire d'une liaison RS232, et enregistrés sur une unité de stockage reliée, ainsi qu'une interface opérateur, à l'unité à microprocesseur du contrôleur GTC.

Le brevet EP-827608 décrit un procédé de test de circuits électriques dans lequel le programme de test est scindé en un élément relatif à la séquence de test qui fait appel à des données contenues dans un champ de données textuelles, et un élément relatif à la commande du dispositif de test.

Le brevet EP-985155 décrit un procédé de test dans lequel un opérateur saisit des informations pour définir une séquence de commandes qui sera appliquée à un dispositif de test relié à un équipement à tester. Pour chaque commande de la séquence de commandes, l'opérateur saisit un numéro de commande, un type de commande, des paramètres ou variables de la commande, et un résultat attendu pour le test correspondant à cette commande. L'opérateur est assisté pour ce faire d'un dictionnaire des différents types de commande applicables à l'équipement à tester, ainsi que d'une base de données regroupant les variables contenues dans les arguments des commandes ainsi que les valeurs que chaque variable peut prendre. L'opérateur peut ensuite faire exécuter par le dispositif de test la ou les commandes saisie(s) et peut archiver les résultats du test. Le dispositif de test peut réaliser une analyse pour vérifier qu'un type de commande saisi appartient au dictionnaire, que les arguments ont une syntaxe correspondant à celle du dictionnaire, et que les variables saisies appartiennent à la base de données de variables.

Le brevet EP-1583289 décrit un système de simulation et de test d'un réseau AFDX qui permet de simuler un ou plusieurs équipements à partir de « produits sur étagères ».

Les procédés et systèmes de simulation et/ou de test connus sont généralement conçus pour tester un nombre restreint d'équipements.

Le test d'un système électronique de bord (avionique) a pour objet de vérifier que les fonctions assignées au système sont effectivement remplies. Ces fonctions sont généralement définies de façon informelle. A partir d'une telle définition, un humain, opérateur de test, peut élaborer une séquence de commandes d'un dispositif (ou « banc ») de test, par exemple comme décrit dans le brevet EP-985155.

Compte tenu de la complexité d'un système à tester, une séquence complète de commandes suffisante pour tester une fonction déterminée du système peut comporter un ou plusieurs milliers de commandes.

L'élaboration des séquences de commandes à appliquer à l'appareil de test nécessite de faire appel à un opérateur hautement qualifié. Du fait de la diversité des équipements faisant partie du système avionique, il est difficile, sinon impossible, de disposer d'un opérateur parfaitement qualifié pour tous les équipements du système et pour toutes les fonctions à remplir par le système dans son ensemble. Il est donc généralement nécessaire de faire appel à plusieurs opérateurs choisis en fonction de leur haute qualification pour une partie seulement des équipements et/ou des fonctions à tester.

La mise au point d'un système électronique de bord nécessite souvent de tester successivement, à plusieurs reprises, l'adéquation du système avec une fonction à remplir déterminée.

En raison notamment du caractère informel de la définition d'une fonction à remplir par un tel système électronique, deux opérateurs distincts peuvent élaborer deux séquences de commandes différentes, et l'exécution de ces deux séquences de commandes produira deux comptes-rendus de test différents.

En outre, pour une commande déterminée, deux opérateurs distincts peuvent choisir deux valeurs distinctes pour un paramètre ou une variable de cette commande, ce qui aboutira également à deux comptes-rendus de test différents. La comparaison de ces deux comptes-rendus peut être dénuée de sens ou peut aboutir à une conclusion erronée.

Un objectif de l'invention est de proposer un procédé et/ou un système de test et de simulation d'un système électronique complexe qui soi(en)t amélioré(s) et/ou qui remédie(nt), en partie au moins, aux lacunes ou inconvénients des procédés et systèmes connus de test.

Selon un aspect de l'invention, il est proposé un procédé de préparation d'un test d'un système électronique comportant plusieurs équipements reliés par au moins une liaison de communication, dans lequel, pour effectuer le test :
- on utilise un banc de test adapté au système électronique à tester que l'on connecte au système à tester, et
- on commande le banc de test selon une séquence de commandes (Scenario_text_file) établie à partir d'au moins une spécification informelle de fonction (Functionnal_chain) à remplir par le système à tester ;
au cours de la préparation du test :
- on crée la séquence de commandes (Scenario_text_file) à partir d'une procédure de test (ATP, Test_Procedure) contenant une séquence d'objets dotés d'attributs, au moins un des objet étant doté d'un attribut de trame déterminant un émetteur et un récepteur parmi les équipements du système SE, et permettant de déterminer un format de transfert de données entre l'émetteur et le récepteur, et
- on enregistre la spécification fonctionnelle informelle (Functionnal_chain), la séquence de commandes (Scenario_text_file), ainsi qu'au moins un lien (Link) identifiant une spécification fonctionnelle informelle (Functionnal_chain) à partir de laquelle une partie au moins de la séquence de commandes a été établie, de sorte qu'après exécution de la séquence de commandes et enregistrement des résultats de test, on peut lire le lien (Link) et identifier de façon univoque la ou les spécification(s) informelle(s) fonctionnelle(s) (Functionnal_chain) correspondant aux résultats de test obtenus.

Selon des caractéristiques préférentielles d'un procédé selon l'intention :
- la spécification fonctionnelle informelle (Functionnal_chain) peut être enregistrée sous forme d'un fichier texte ;
- la séquence de commandes (Scenario_test_file) peut être enregistrée sous forme d'un fichier texte ;
- le lien (Link) peut comporter l'adresse d'une partie au moins de la séquence de commandes (Scenario_text_file) - ou l'adresse d'un fichier contenant une partie au moins de cette séquence - ainsi que l'adresse de la spécification fonctionnelle informelle (Functionnal_chain) - ou l'adresse d'un fichier contenant cette spécification -;
- on crée la séquence de commandes (Scenario_text_file) à partir d'une procédure de test (ATP, Test_Procedute) contenant une séquence d'objets dotés d'attributs ;
- la procédure de test (ATP, Test_Procedure) peut contenir des objets de simulation (TestSimu), des objets d'observation (TestSpy), des objets de contrôle (TestCheck), des objets de fonction à tester (TestFunct) ;
- la procédure de test (ATP, Test_Procedure) contient des données d'organisation hiérarchique des objets, en particulier des données d'organisation hiérarchique des objets de fonction à tester (TestFunct) ;
- au cours de la création d'une séquence de commandes (Scenario_text_file) à partir d'une procédure de test (ATP, Test_Procedure) contenant des objets de simulation (TestSimu), des objets d'observation (TestSpy), et/ou des objets de contrôle (TestCheck), on choisit ces objets parmi des objets (POIL_BAR) enregistrés dans une base de données (Interf_DB) de configuration des équipements - et des échanges de données entre les équipements - du système à tester.

Dans cette base de données, un objet est défini par un nom unique ; parmi ces objets, des objets impliquant un transfert de données par une des liaisons/bus du système à tester présentent un attribut de trame qui détermine un unique équipement émetteur et un unique équipement récepteur. Cette base contient en outre les informations nécessaires à la définition du signal physique échangé entre cet émetteur et ce récepteur du système à tester, notamment la période et le format de trame.

Selon un autre aspect de l'invention, il est proposé un procédé de réalisation d'un test d'un système - électronique comportant plusieurs équipements reliés par au moins une liaison de communication, dans lequel on prépare le test par un procédé selon l'invention, puis ;
- on connecte un banc de test au système électronique à tester,
- on lit une séquence de commandes (Scenario_text_file) et on commande le banc de test selon la séquence de commandes (Scenazio_text_file),
- on enregistre des résultats de test dans un fichier (Res_File), et
- on associe aux résultats de test une spécification fonctionnelle informelle (Functionnal_chain) liée à la séquence de commandes (Scenatio_text_file) par le lien (Link) préalablement enregistré.

Selon un autre aspect de l'invention, il est proposé un procédé d'un test d'un système électronique comportant plusieurs équipements reliés par au moins une liaison de communication, dans lequel ;
on prépare le test:
- en préparant une procédure de test formelle (ATP, Test_Procedure) que l'on relie par un ou plusieurs liens (Link) à une ou plusieurs définition(s) fonctionnelle(s) (Funetionnal_chain) d'exigences pour le système et,
- en produisant automatiquement un scénario de test (Scenuio_text_file) permettant de piloter un banc de test adapté et connecté au système à tester, en utilisant une base de données (Interf_DB) contenant une définition de tous les signaux susceptibles d'être échangés par les équipements du système à tester,
puis, suite à la préparation, on exécute le scénario de test (Scenario_text_file) sur le banc de test en contrôlant et en enregistrant dans un rapport d'exécution (Res_File) l'état du système à tester par rapport à la description fournie dans le scénario de test, et
- on reporte automatiquement les résultats du rapport d'exécution dans la procédure de test (ATP, Test_Procedure, ATR),
le(s) lien(s) permettant d'identifier de façon univoque l'ensemble des exigences du système à tester qui ont été testées par l'exécution du scénario de test et qui correspondent aux résultats obtenus.

L'invention permet de produire des rapports de traçabilité automatique entre les résultats de test (Res_File, ATR) et les exigences fonctionnelles du système, et permet de garantit l'adéquation parfaite entre la description des tests - par la procédure ATP, Test_Procedure - et leur exécution sur le système à tester.

Certaines au moins des opérations de la phase préparatoire et/ou de la phase de test en tant que tel, des procédés selon l'invention peuvent être mises en oeuvre par une unité électronique de traitement de données, telle qu'un calculateur, fonctionnant sous la commande d'un programme.

Ainsi, selon un autre aspect de l'invention, il est proposé un programme comportant un code fixé sur un support - tel qu'une mémoire - ou matérialisé par un signal, le code étant lisible et/ou exécutable par au moins une unité de traitement de données - telle qu'un processeur, pour stimuler et tester le fonctionnement (bon ou mauvais) d'un système électronique complexe, le code comportant des segments de code pour effectuer des opérations d'un procédé selon l'invention.

Selon un autre aspect de l'invention, il est proposé un système de test d'un système électronique complexe, qui est programmé pour exécuter des opérations d'un procédé selon l'invention.

D'autres aspects, caractéristiques, et avantages de l'invention apparaissent dans la description suivante, qui se réfère aux dessins annexés et qui illustre, sans aucun caractère limitatif, des modes préférés de réalisation de l'invention.
La figure 1 illustre schématiquement un système de test relié aux bus d'un système électronique d'un giravion comportant des calculateurs redondants interconnectés par un bus redondant.
La figure 2 illustre schématiquement l'enchaînement d'étapes d'un procédé de préparation de test et d'un procédé de test selon l'invention.
La figure 3 illustre schématiquement l'enchaînement d'étapes pour l'établissement d'une procédure de test dans un procédé de préparation de test selon l'invention.
La figure 4 illustre schématiquement l'enchaînement d'étapes pour l'établissement d'une séquence de commandes de test à partir d'une procédure de test dans un procédé de préparation de test selon l'invention.
La figure 5 illustre schématiquement l'enchaînement d'étapes pour l'exécution d'une procédure de test dans un procédé de test selon l'invention.
La figure 6 illustre schématiquement des modules d'un système de test selon l'invention.
La figure 7 illustre un exemple de structure d'une procédure de test d'un procédé selon l'invention et son lien avec une spécification fonctionnelle informelle.
La figure 8 illustre l'utilisation de la procédure de test de la figure 7 pour élaborer automatiquement une séquence de commandes de test conformément à un aspect de l'invention.
La figure 9 est un graphe illustrant schématiquement un exemple d'interface graphique présentée à un opérateur exécutant un test préparé conformément à l'invention.
La figure 10 illustre schématiquement l'élaboration d'un rapport de test en fonction de résultats de test et de la procédure de test correspondante.

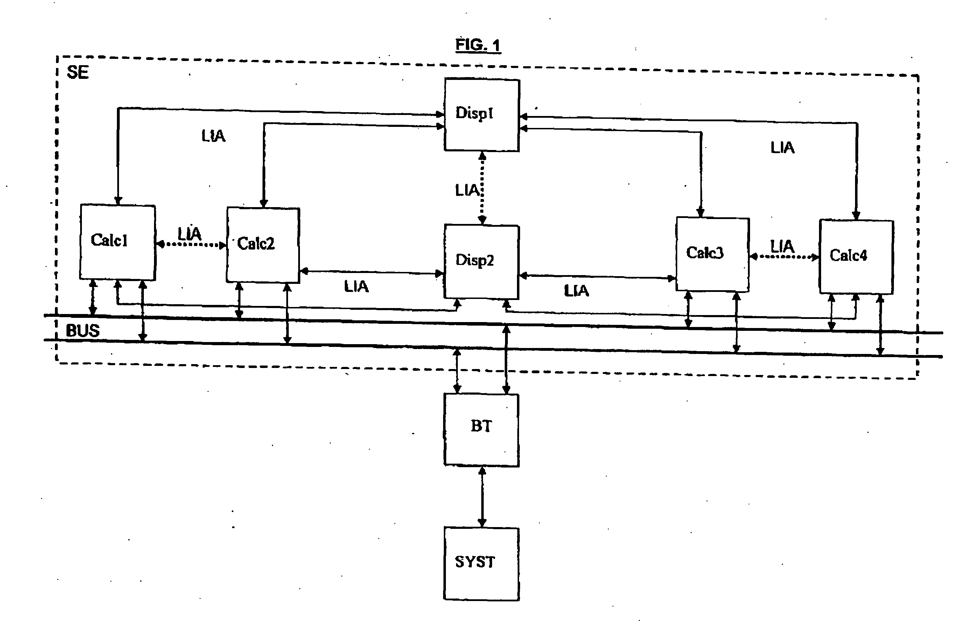

Pat référence à la figure 1 en particulier, l'invention s'applique à un système électronique SE d'un giravion, qui comporte deux calculateurs redondants CALC1 et CALC2 dont la fonction est de gérer le système SE.

Le système SE comporte en outre deux calculateurs redondants CALC3 et CALC4 dont la fonction est de gérer le fonctionnement du ou des moteurs du giravion.

Pour ne pas nuire à la clarté de la figure, d'autres calculateurs et équipements électroniques faisant habituellement partie de l'avionique SE d'un giravion, tels que les équipements de navigation et de communication, ne sont pas représentés sur cette figure.

Le système SE comporte également deux afficheurs multifonction DISP1 et DISP2.

Les calculateurs du système SE sont reliés à un bus redondant BUS, par exemple un bus MIL-STD-1553. Les calculateurs sont en outre reliés entre eux par une ou plusieurs liaisons point à point LIA, telles que des liaisons RS485 ou ARINC 429. Chaque calculateur est également relié par une liaison LIA à chacun des deux afficheurs.

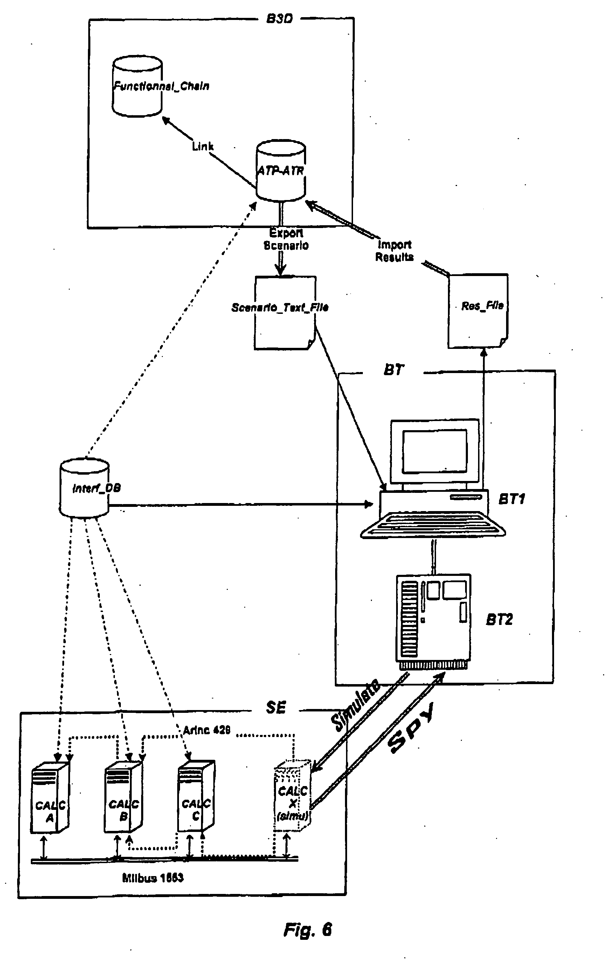

Comme illustré figures 1 et 6, pour le test du système SE et/ou la simulation du fonctionnement d'un ou plusieurs de ses équipements, un banc de test BT est relié aux bus BUS du système SE.

Par référence à la figure 6, le banc BT peut comporter un ordinateur BT1 utilisable par un opérateur réalisant un test, et une baie de test BT2 pilotée par l'ordinateur BT1.

La baie BT2 est reliée au bus du système SE à tester pour simuler un équipement du système SE tel que le calculateur CALCX illustré en pointillé figure 6, et pout surveiller/enregistrer les signaux/données échangé(e)s par les équipements du système SE pendant un test.

La baie BT2 peut comporter une unité de commande à microprocesseur, des unités d'entrée/sortie analogiques et numériques, et comporte des interfaces appropriées pour sa connexion aux bus BUS d'une part, et aux liaisons LIA d'autre part. Les composants de la baie BT2 peuvent être eux-mêmes interconnectés par un bus VME par exemple.

Pour le test et/ou la simulation du système SE, le banc de test BT est relié à - et piloté par - un système de test SYST conforme à l'invention qui délivre à cet effet au banc BT des signaux et/ou données correspondant aux séquences de commandes de test, et qui reçoit ensuite du banc BT des signaux et/ou données correspondant aux résultats de l'exécution de ces commandes.

Le système de test SYST inclue (cf. figure 6) une base de données documentaire B3D comportant des procédures de test ATP, des procédures de test ATR affectées des résultats de test correspondant, des spécifications fonctionnelles Functionnal_chain contenant des exigences fonctionnelles de tout ou partie du système à tester, ainsi qu'une base de données Interf_DB contenant les spécifications des échanges de signaux/donnéés - par les bus et liaisons BUS, LIA - entre les équipements CALCA, CALCB, CALCC, CALCX du système SE.

Selon un aspect de l'invention, une procédure de test formalisée est définie sous la forme d'un ensemble d'objets d'une base de données et est liée aux documents de spécifications des exigences du système à tester. Un scénario de test - ou séquence de commandes de test - est automatiquement généré à partir de la procédure de test puis est exécuté sur le banc de test temps réel avec enregistrement automatique des résultats ; l'invention permet d'assurer une traçabilité complète, de la spécification système jusqu'aux résultats de test.

Des classes d'objet sont créées dans la base de données afin de formaliser la description intégrale de toutes les opérations à effectuer lors de l'exécution d'un test. Ces opérations peuvent être de type manuelle (vérification par l'ingénieur d'essai du comportement d'un équipement du système) ou automatique (simulation ou espionnage d'une valeur de données circulant dans le flot de données du système). Les tests sont découpés en tests « élémentaires » (plus petite partie de la procédure exécutable individuellement).

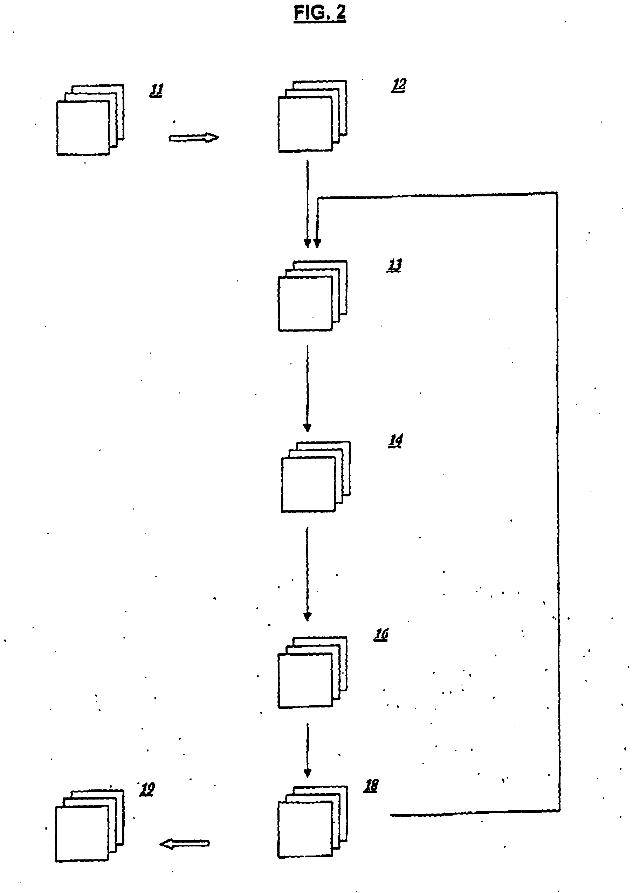

La préparation et l'exécution d'une séquence de commandes de test, sous le contrôle du système SYST, peuvent comporter les étapes successives suivantes dont l'enchaînement est schématiquement représenté figures 2 à 5 ;
- dans une base de données d'objets dotés d'attributs, une procédure de test est créée par saisie d'informations (étape 13) et/ou par importation (étape 11) de données informelles de spécification de fonctions à remplir par le système SE, qui sont contenues dans un texte ou un tableau par exemple, suivie d'une mise en forme (étape 12) des données informelles au format de la base de données d'objets;
- on définit ensuite (étape 14), pour la procédure de test ou pour au moins un objet de cette procédure, un lien entre l'objet (respectivement la procédure) et une spécification informelle de fonction ;
- pour l'exécution du test (étape 16), on génère au moins une séquence de commandes à partir de la procédure de test, on délivre les commandes au banc de test, on enregistre les résultats de test transmis au système SYST par le banc BT, et on modifie automatiquement des attributs des objets TestCheck en fonction de ces résultats ;
- on établit (étape 18) un rapport de synthèse des tests effectués que l'on exporte (étape 19) le cas échéant vers une application différente.

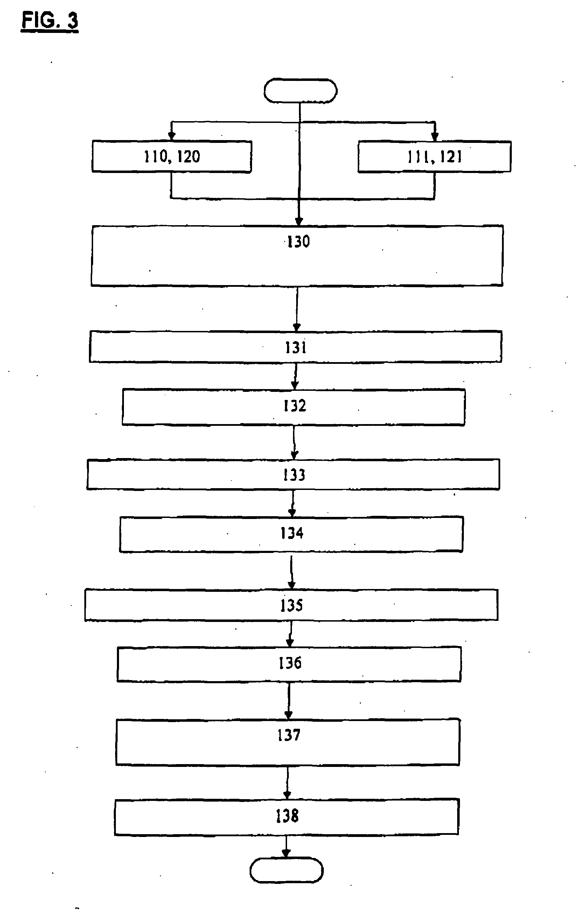

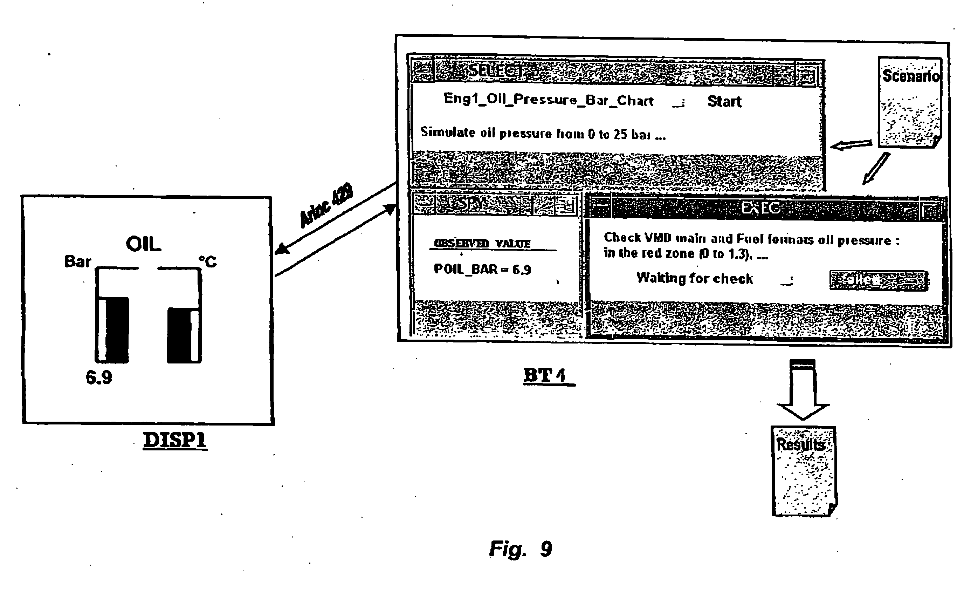

Par référence aux figures 3 et 7 à 10 notamment, une procédure de test comporte au moins une séquence hiérarchisé d'objets appartenant à différentes classes d'objet telles que, par exemple ;
- une classe d'objets TestFunct contenant chacun un intitulé relatif à une partie de la procédure, tel que « 1.1 engine t 700 status monitoring » ou « 1.1.1 engine ½ oil pressure bar-chart »;
- une classe d'objets TestIdent contenant chacun un identifiant de test élémentaire tel que « [eng1_oil_pressure_bar_chart] » qui est présenté (dans la fenêtre SELECT figure 9) à un opérateur exécutant la procédure ;
- une classe d'objets TestDesc contenant chacun une description de la partie concernée de la procédure telle que « simulate oil pressure from 0 to 25 bar and then going below 3 bar for checking displayed warnings and cautions » ; cette description est également présentée dans la fenêtre SELECT figure 9 ;
- une classe d'objets TestProc contenant chacun un message d'instruction tel que « power on PMC and check MFD oil pressure display according to simulated value » destiné à indiquer à un opérateur exécutant la procédure, l'action qu'il doit effectuer sur le système SE à tester; ce message peut être présenté à l'opérateur dans une fenêtre similaire à la fenêtre EXEC figure 9 ;
- une classe d'objets TestSimu contenant chacun une commande du banc de test, telle que « POIL_BAR=LIST(0,0.1,1.2,1.3,1.4,2.1,1.2,6.8,6.9,8.2,8.3,25) », destinée à provoquer l'envoi par le banc de test, à au moins un équipement du système testé SE, via le bus BUS ou une des liaisons LIA, de données simulant par exemple un signal délivré par un capteur, pour simuler ce dernier;
- une classe d'objets TestSpy contenant chacun une commande du banc de test, telle que « POIL_BAR», destinée à provoquer l'envoi au banc de test, par au moins un équipement du système testé SE, via le bus BUS ou une des liaisons LIA, de données délivrées par cet équipement, pour surveiller ce dernier; cette donnée est présentée à l'opérateur au moment du test dans la fenêtre SPY figure 9 ;
- une classe d'objets TestCheck contenant chacun une instruction de vérification de l'état du système testé SE à effectuer par l'opérateur, telle que « Check VMD main ... of digital value at 3 bar.», destinée à provoquer l'enregistrement d'une donnée de constatation de succès « passed » ou d'échec « failed » qui peut être saisie par l'opérateur au cours du test, dans la fenêtre EXEC figure 9.

Dans le mode de réalisation correspondant à la figure 3, on importe le cas échéant des données de définition d'objets à partir d'un tableur (opérations 110, 120) ou d'un fichier texte (opérations 111, 121) ; on procède à la saisie, sélection, extraction, ou mise en forme d'objets TestFunc, TestIdent, TestDesc, et/ou TestProc (opération 130).

On procède à la même opération de saisie/importation pour les objets TestSimu et TestSpy (opérations 131 et 133 respectivement), dont on vérifie le format et le contenu (opérations 132 et 134 respectivement) par comparaison avec des données de la base Interf_DB.

On saisit également.le contenu des objets TestCheck (opération 135) et on modifie ou on ajoute des attributs (opération 136) à tout ou partie de ces objets.

On peut ensuite créer et enregistrer un lien (opération 137) entre la procédure définie par une séquence de ces objets et une ou plusieurs spécifications fonctionnelles en langage naturel correspondant à ces objets, et enregistrer (opération 138) la procédure ainsi définie ATP, Test_Procedure.

D'autres classes d'objets peuvent être prévues, par exemple une classe d'objets contenant chacun une description ou identification d'un moyen de test déterminé devant être inclus dans le banc de test pour réaliser un test déterminé.

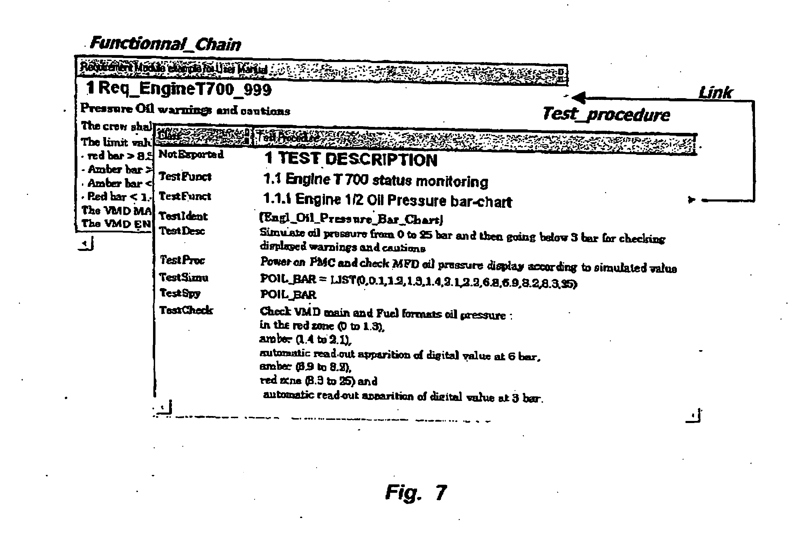

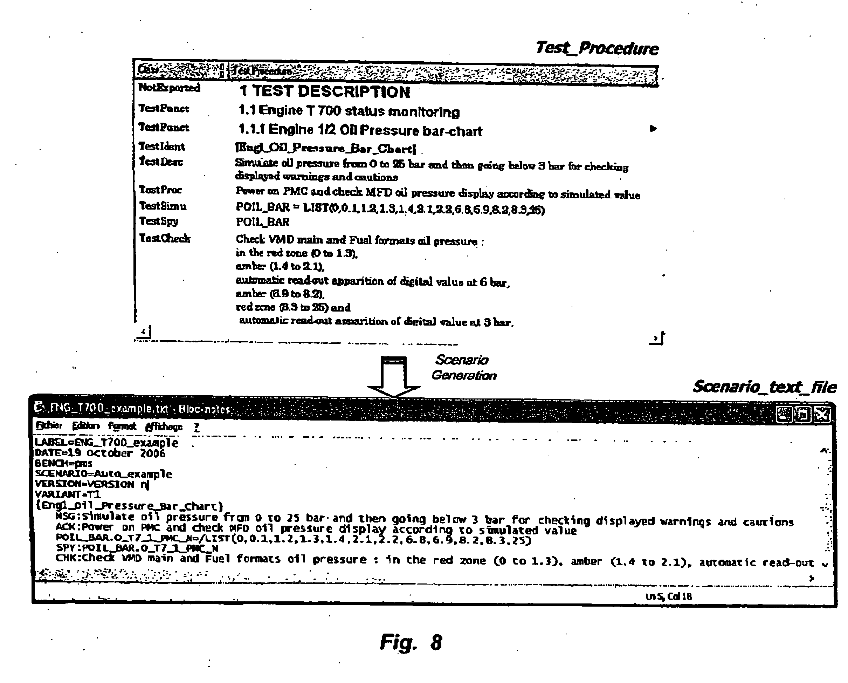

Les figures 7, 8 et 10 donnent un aperçu du contenu de la base de données documentaire de définition de tests, sous la forme d'un tableau dans lequel les données correspondant à un objet forent une ligne. La classe de l'objet apparaît dans une première colonne (colonne de gauche figures 7 et 8), le contenu de l'objet apparaît dans une seconde colonne, et les attributs de l'objet apparaissent dans d'autres colonnes.

Parmi ces attributs, il est notamment prévu un attribut de trame pour les objets de la classe d'objet TestSimu et TestSpy notamment. Lors de la génération automatique d'une séquence de commandes de test à partir d'une procédure incluant un objet présentant cet attribut, cet attribut est utilisé pour adapter la commande de test à un protocole - ou format d'échange de données - adapté au protocole utilisé par des équipements du système SE pour communiquer. L'attribut de trame est utilisé pour spécifier le routage physique défini sur le banc de test.

A titre d'exemple, comme illustré figure 8, un tel attribut de trame associé à l'objet TestSimu contenant la commande « POIL_BAR=LIST(0,0.1,1.2,1.3,1.4,2.1,1.2,6.8,6.9,8.2,8.3,25) », provoque, lors de la création d'un fichier de commande au format texte illustré dans le cadre inférieur de cette figure, la modification du contenu de cette commande qui devient « POIL_BAR.O_T7_1_PMC_N=/LIST(0,0.1,1.2,1.3,1.4,2.1,1.2,6.8,6.9,8.2,8 .3,25) ».

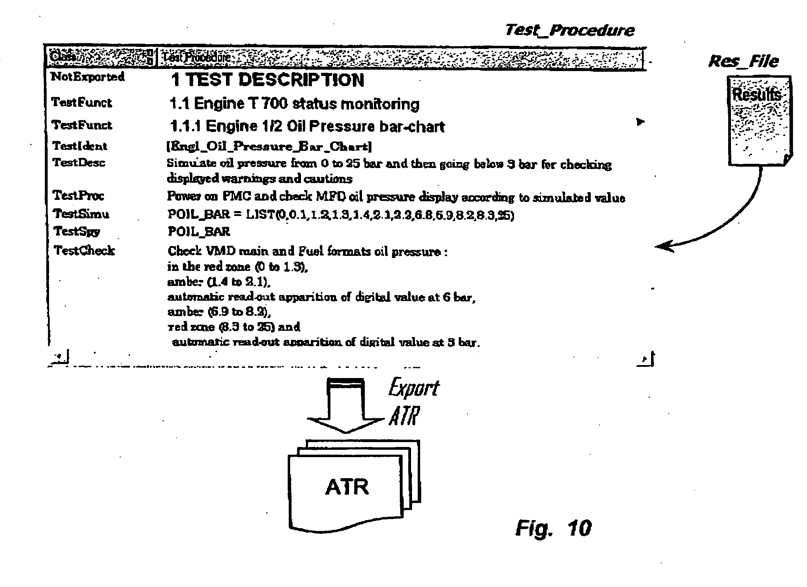

Parmi ces attributs, il est également prévu un attribut de résultat pour les objets de la classe d'objets TestCheck notamment. Cet attribut peut être modifié, lors de la génération automatique d'un rapport de test, pour inclure le résultat, tel que le résultat « failed » figure 10, d'une vérification effectuée par l'opérateur au cours du test.

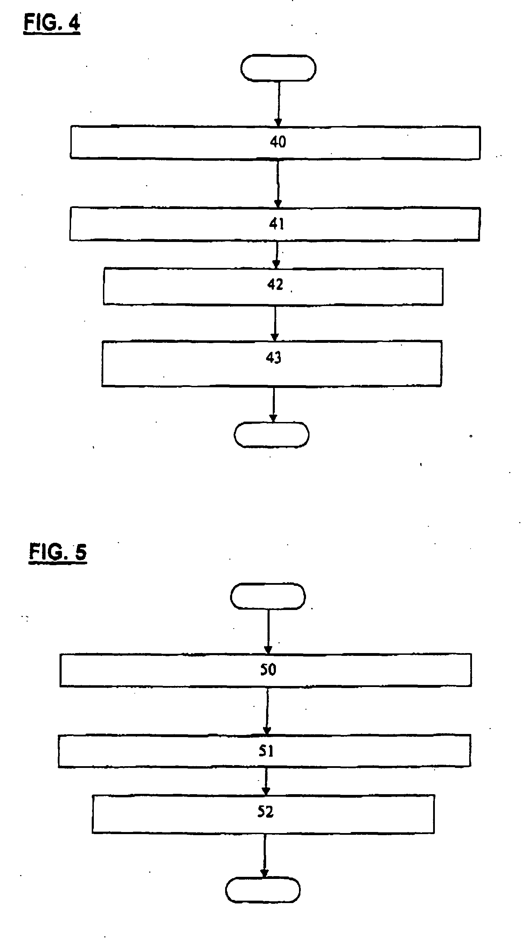

Par référence aux figures 4 et 8, un fichier texte avec une syntaxe particulière est généré par extraction dans le texte de la procédure de l'ensemble des instructions à utiliser sur le banc de test temps réel.

A cet effet, on peut procéder successivement à une lecture (étape 40) d'une procédure de test ATP, Test_Procedure, à une lecture (étape 41) d'une configuration du banc de test, à une lecture (étape 42) d'une configuration du système à tester, pour la création (étape 43) et l'enregistrement d'une séquence de commandes correspondant à cette procédure et à ces configurations.

Pour l'exécution du test illustrée figure 5, un scénario générique peut lire/interpréter (étape 50) le fichier texte des instructions de test. Il permet d'exécuter (étape 51) - séquentiellement ou non - l'ensemble des tests élémentaires décrit dans la procédure associée et effectue (étape 52) l'enregistrement des résultats en cours de test dans un autre fichier texte.

Par référence aux figures 6 et 10 notamment, le fichier texte Res_File (fig. 6) contenant les résultats de test est ensuite utilisé pour mettre à jour automatiquement le rapport de test dans la base de données documentaire. Celle-ci est ensuite utilisée pour produire un document final d'acceptation ATR (« Acceptance Test Report ») combinant la procédure de test ATP utilisée et les résultats obtenus lors de l'exécution de la séquence de commandes correspondant à cette procédure ATP.

Par référence à la figure 9, lors de l'exécution d'un test, des fenêtres de dialogue et de saisie SELECT, SPY, et EXEC sont présentées à l'opérateur sur l'écran de l'ordinateur BT1 du banc BT, dont l'existence et le contenu résultent respectivement de l'existence et du contenu des objets de classe TestIdent, TestDesc, et TestProc décrits ci avant.

La gestion de ces fenêtres est pilotée par la séquence de commandes, et les résultats de test sont enregistrés dans le fichier Results, Res_File (fig. 6).

L'invention permet d'assurer que les essais sont effectués strictement comme définis dans la procédure. L'exécution des tests de non régression est facilitée.

L'exécution des tests peut être effectué par un opérateur n'ayant pas une connaissance approfondie du système à tester SE.

L'invention permet une traçabilité complète du processus dès l'application de la procédure : elle est assurée entre les spécifications systèmes et les résultats des procédures de validation par l'intermédiaire de la base de données documentaire et des scénarios de test automatiques.

## Revendications

1. Procédé de préparation d'un test d'un système électronique (SE) comportant plusieurs équipements (CALC1, CALC2, DISP1, DISP2, CALC3, CALC4) reliés par au moins une liaison de communication (LIA, BUS), dans lequel, pour effectuer le test :
- on utilise un banc de test (BT) adapté au système électronique (SE) à tester que l'on connecte au système à tester, et
- on commande le banc de test selon une séquence de commandes (Scenario_text_file) établie à partir d'au moins une spécification fonctionnelle informelle (Functionnal_chain),
le procédé de préparation de test étant **caractérisé en ce que** :
- on crée la séquence de commandes (Scenario_text_file) à partir d'une procédure de test (ATP, Test_Procedure) contenant une séquence d'objets dotés d'attributs, au moins un des objet étant doté d'un attribut de trame déterminant un émetteur et un récepteur parmi les équipements du système SE, et permettant de déterminer un format de transfert de données entre l'émetteur et le récepteur, et
- on enregistre la spécification fonctionnelle informelle (Functionnal_chain), la séquence de commandes (Scenario_text_file), ainsi qu'au moins un lien (Link) identifiant une spécification fonctionnelle informelle (Functionnal_chain) à partir de laquelle une partie au moins de la séquence de commandes a été établie, de sorte qu'après exécution de la séquence de commande et enregistrement des résultats de test, on peut lire le lien (Link) et identifier de façon univoque la ou les spécification(s) fonctionnelle(s) informelle(s) (Functionnal_chain) correspondant aux résultats de test obtenus.

2. Procédé selon la revendication 1 dans lequel la spécification fonctionnelle informelle (Functionnal_chain) est enregistrée sous forme d'un fichier texte.

3. Procédé selon la revendication 1 ou 2 dans lequel la séquence de commandes (Scenario_text_file) est enregistrée sous forme d'un fichier texte.

4. Procédé selon l'une quelconque des revendications 1 à 3 dans lequel le lien (Link) comporte l'adresse d'une séquence de commandes (Scenario_text_file) et l'adresse d'une spécification fonctionnelle informelle (Functionnal_chain).

5. Procédé selon l'une quelconque des revendications 1 à 4 dans lequel la procédure de test (ATP, Test_Procedure) contient des objets de simulation (TestSimu), des objets d'observation (TestSpy), et des objets de contrôle (TestCheck).

6. Procédé selon l'une quelconque des revendications 1 à 5 dans lequel la procédure de test (ATP, Test_Procedure) contient des objets de fonction à tester (TestFunct).

7. Procédé selon l'une quelconque des revendications 1 à 6 dans lequel la procédure de test (ATP, Test_Procedure) contient des données d'organisation hiérarchique des objets de fonction à tester (TestFunct).

8. Procédé selon l'une quelconque des revendications 1 à 7 dans lequel, pour créer la séquence de commandes (Scenario_text_file) à partir d'une procédure de test (ATP, Test_Procedure) contenant des objets de simulation (TestSimu), des objets d'observation (TestSpy), et/ou des objets de contrôle (TestCheck), on choisit ces objets parmi des objets enregistrés dans une base de données (Interf_DB) de configuration des équipements - et des échanges de données entre les équipements - du système à tester.

9. Procédé de réalisation d'un test d'un système électronique (SE) comportant plusieurs équipements (CALC1, CALC2, DISP1, DISP2, CALC3, CALC4) reliés par au moins une liaison de communication (LIA, BUS), dans lequel on prépare le test par un procédé selon l'une quelconque des revendications 1 à 8, puis :
- on connecte un banc de test (BT) au système électronique à tester,
- on lit une séquence de commandes (Scenario_text_file) et on commande le banc de test selon la séquence de commandes (Scenario_text_file),
- on enregistre des résultats de test, et
- on associe aux résultats de test au moins une spécification fonctionnelle (Functionnal_chain) liée à la séquence de commandes (Scenario_text_file) par un lien (Link) préalablement enregistré.

10. Procédé de réalisation d'un test d'un système électronique (SE) selon la revendication 9 comportant plusieurs équipements (CALC1, CALC2, DISP1, DISP2, CALC3, CALC4) reliés par au moins une liaison de communication (LIA, BUS), dans lequel
on prépare le test en :
- préparant une procédure de test formelle (ATP, Test_Procedure) que l'on relie par un ou plusieurs liens (Link) à une ou plusieurs spécification(s) fonctionnelle(s) (Functionnal_chain) d'exigences pour le système (SE),
- en produisant automatiquement une séquence de commandes (Scenario_text_file), à partir de ladite procédure de test(ATP, Test_Procedure), permettant de piloter un banc de test (BT) adapté et connecté au système (SE) à tester, en utilisant une base de données (Interf_DB) contenant une définition de tous les signaux susceptibles d'être échangés par les équipements du système (SE), et
- en enregistrant ladite spécification fonctionnelle (Functionnal_chain), ladite séquence de commandes (Scenario_text_file), ainsi que ledit un ou plusieurs liens (Link) ; puis:
- on exécute le scénario de test (Scenario_text_file) sur le banc de test en contrôlant et en enregistrant dans un rapport d'exécution (Res_File) l'état du système (SE) par rapport à la description fournie dans le scénario de test, et
- on reporte automatiquement les résultats du rapport d'exécution dans la procédure de test (ATP, Test_Procedure, ATR), le(s) lien(s) permettant d'identifier de façon univoque l'ensemble des exigences du système (SE) qui ont été testées par l'exécution du scénario de test et qui correspondent aux résultats obtenus.

11. Programme comportant un code fixé sur un support ou matérialisé par un signal, le code étant lisible et/ou exécutable par au moins une unité de traitement de données pour stimuler et tester le fonctionnement d'un système électronique (SE), le code comportant des segments de code pour effectuer des opérations d'un procédé selon l'une quelconque des revendications 1 à 8.

12. Système (SYST, BT) de test d'un système électronique (SE), qui est programmé pour exécuter des opérations d'un procédé selon l'une quelconque des revendications 1 à 8.

## Claims

1. A process for the preparation of a test of an electronic system (SE) comprising a plurality of items of equipment (CALC1, CALC2, DISP1, DISP2, CALC3, CALC4) which are connected by at least one communication link (LIA, BUS), in which, in order to carry out the test:
- a test bed (BT) adapted to the electronic system (SE) to be tested is used, which is connected to the system to be tested, and
- the test bed is controlled in accordance with a command sequence (Scenario_text_file) established from at least one informal functional specification (Functionnal_chain [sic]),
the test preparation process being **characterised in that**:
- the command sequence (Scenario_text_file) is created from a test procedure (ATP, Test_Procedure) containing a sequence of objects provided with attributes, at least one of the objects being provided with a frame attribute which determines a transmitter and a receiver from among the items of equipment of the system SE, and which makes it possible to determine a data transfer format between the transmitter and the receiver, and
- the informal functional specification (Functionnal_chain), the command sequence (Scenario_text_file), and also at least one link (Link) which identifies an informal functional specification (Functionnal_chain) from which at least part of the command sequence has been established are recorded, so that, once the command sequence has been executed and the test results recorded, the link (Link) can be read and the informal functional specification(s) (Functionnal_chain) corresponding to the test results obtained can be identified unequivocally.

2. A process according to Claim 1, in which the informal functional specification (Functionnal_chain) is recorded in the form of a text file.

3. A process according to Claim 1 or 2, in which the command sequence (Scenario_text_file) is recorded in the form of a text file.

4. A process according to any one of Claims 1 to 3, in which the link (Link) comprises the address of a command sequence (Scenario_text_file) and the address of an informal functional specification (Functionnal_chain).

5. A process according to any one of Claims 1 to 4, in which the test procedure (ATP, Test_Procedure) contains simulation objects (TestSimu), observation objects (TestSpy) and check objects (TestCheck).

6. A process according to any one of Claims 1 to 5, in which the test procedure (ATP, Test_Procedure) contains objects of the function to be tested (TestFunct).

7. A process according to any one of Claims 1 to 6, in which the test procedure (ATP, Test_Procedure) contains hierarchical organisation data of the objects of the function to be tested (TestFunct).

8. A process according to any one of Claims 1 to 7, in which, in order to create the command sequence (Scenario_text_file) from a test procedure (ATP, Test_Procedure) containing simulation objects (TestSimu), observation objects (TestSpy) and/or check objects (TestCheck), these objects are selected from among objects recorded in a database (Interf_DB) for configuring the items of equipment - and the exchanges of data between the items of equipment - of the system to be tested.

9. A process for carrying out a test of an electronic system (SE) comprising a plurality of items of equipment (CALC1, CALC2, DISP1, DISP2, CALC3, CALC4) which are connected by at least one communication link (LIA, BUS), in which the test is prepared by a process according to any one of Claims 1 to 8, then:
- a test bed (BT) is connected to the electronic system to be tested,
- a command sequence (Scenario_text_file) is read and the test bed is controlled in accordance with the command sequence (Scenario_text_file),
- test results are recorded, and
- at least one functional specification (Functionnal_chain) linked to the command sequence (Scenario_text_file) by a link (Link) which has been recorded previously is associated with the test results.

10. A process for carrying out a test of an electronic system (SE) according to Claim 9, comprising a plurality of items of equipment (CALC1, CALC2, DISP1, DISP2, CALC3, CALC4) which are connected by at least one communication link (LIA, BUS), in which
the test is prepared by:
- preparing a formal test procedure (ATP, Test_Procedure) which is linked by one or more links (Link) to one or more functional specification(s) (Functionnal_chain) of demands for the system (SE),
- automatically producing a command sequence (Scenario_text_file) from said test procedure (ATP, Test_Procedure), which makes it possible to operate a test bed (BT) which is adapted and connected to the system (SE) to be tested, using a database (Interf_DB) containing a definition of all the signals capable of being exchanged by the items of equipment of the system (SE);and
- recording said functional specification (Functionnal_chain), said command sequence (Scenario_text_file), and also said one or more links (Link);
then:
- the test scenario (Scenario_text_file) is executed on the test bed by checking and recording in an execution report (Res_File) the state of the system (SE) relative to the description provided in the test scenario, and
- the results of the execution report are automatically transferred into the test procedure (ATP, Test_Procedure, ATR), the link(s) making it possible to identify unequivocally all the demands of the system (SE) which have been tested by executing the test scenario and which correspond to the results obtained.

11. A programme comprising a code affixed to a medium or embodied by a signal, the code being readable and/or executable by at least one data-processing unit for stimulating and testing the operation of an electronic system (SE), the code comprising segments of code for carrying out the operations of a process according to any one of Claims 1 to 8.

12. A system (SYST, BT) for testing an electronic system (SE), which is programmed to execute operations of a process according to any one of Claims 1 to 8.

## Patentansprüche

1. Verfahren zum Vorbereiten eines Tests eines elektronischen Systems (SE), das mehrere Geräte (CALC1, CALC2, DISP1, DISP2, CALC3, CALC4) umfasst, die durch wenigstens eine Kommunikationsverbindung (LIA, BUS) verbunden sind, in dem, um den Test auszuführen:
- eine Testbank (BT) verwendet wird, die an das zu testende elektronische System (SE) angepasst ist und die mit dem zu testenden System verbunden wird, und
- die Testbank gemäß einer Folge von Befehlen (Scenario_text_file) anhand wenigstens einer informellen, funktionalen Spezifikation (Functionnal_chain) gesteuert wird,
wobei das Testvorbereitungsverfahren **dadurch gekennzeichnet ist, dass**:
- die Folge von Befehlen (Scenario_text_file) anhand einer Testprozedur (ATP, Test_Procedure) erzeugt wird, die eine Folge von mit Attributen versehenen Objekten enthält, wobei wenigstens eines der Objekte mit einem Rahmenattribut versehen ist, das einen Sender und einen Empfänger unter den Geräten des Systems SE bestimmt und ermöglicht, ein Format für die Datenübertragung zwischen dem Sender und dem Empfänger zu bestimmen, und
- die informelle funktionale Spezifikation (Functionnal_chain), die Folge von Befehlen (Scenario_text_file) sowie wenigstens eine Verbindung (Link), die eine informelle funktionale Spezifikation (Functionnal_chain) identifiziert, anhand derer wenigstens ein Teil der Folge von Befehlen gebildet worden ist, eingetragen werden, derart, dass nach der Ausführung der Folge von Befehlen und dem Eintragen der Testergebnisse die Verbindung (Link) gelesen werden kann und die eine oder die mehreren informellen funktionalen Spezifikationen (Functionnal_chain), die den erhaltenen Testergebnissen entsprechen, eindeutig identifiziert werden können.

2. Verfahren nach Anspruch 1, wobei die informelle funktionale Spezifikation (Functionnal_chain) in Form einer Textdatei eingetragen wird.

3. Verfahren nach Anspruch 1 oder 2, wobei die Folge von Befehlen (Scenario_text_file) in Form einer Textdatei eingetragen wird.

4. Verfahren nach einem der Ansprüche 1 bis 3, wobei die Verbindung (Link) die Adresse einer Folge von Befehlen (Scenario_text_file) und die Adresse einer informellen funktionalen Spezifikation (Functionnal_chain) enthält.

5. Verfahren nach einem der Ansprüche 1 bis 4, wobei die Testprozedur (ATP, Test_Procedure) Simulationsobjekte (TestSimu), Beobachtungsobjekte (TestSpy) und Kontrollobjekte (TestCheck) enthält.

6. Verfahren nach einem der Ansprüche 1 bis 5, wobei die Testprozedur (ATP, Test_Procedure) zu testende Funktionsobjekte (TestFunct) enthält.

7. Verfahren nach einem der Ansprüche 1 bis 6, wobei das Testverfahren (ATP, Test_Procedure) Daten einer hierarchischen Organisation von zu testenden Funktionsobjekten (TestFunct) enthält.

8. Verfahren nach einem der Ansprüche 1 bis 7, wobei, um die Folge von Befehlen (Scenario_text_file) anhand einer Testprozedur (ATP, Test_Procedure) zu erzeugen, die Simulationsobjekte (TestSimu), Beobachtungsobjekte (TestSty) und/oder Kontrollobjekte (TestCheck) enthält, diese Objekte unter den eingetragenen Objekten in einer Datenbank (Interf_DB) für die Konfiguration der Geräte - und unter Datenaustauschvorgängen zwischen den Geräten - des zu testenden Systems gewählt werden.

9. Verfahren zum Ausführen eines Tests eines elektronischen Systems (SE), das mehrere Geräte (CALC1, CALC2, DISP1, DISP2, CALC3, CALC4) enthält, die durch wenigstens eine Kommunikationsverbindung (LIA, BUS) verbunden sind, in dem der Test durch ein Verfahren nach einem der Ansprüche 1 bis 8 vorbereitet wird, woraufhin:
- eine Testbank (BT) mit dem zu testenden elektronischen System verbunden wird,
- eine Folge von Befehlen (Scenario_text_file) gelesen wird und die Testbank gemäß der Folge von Befehlen (Scenario_text_file) gesteuert wird,
- die Testergebnisse eingetragen werden und
- den Testergebnissen wenigstens eine funktionale Spezifikation (Functionnal_chain) zugeordnet wird, die mit der Folge von Befehlen (Scenario_text_file) über eine vorher eingetragene Verbindung (Link) verbunden ist.

10. Verfahren zum Ausführen eines Tests eines elektronischen Systems (SE) nach Anspruch 9, das mehrere Geräte (CALC1, CALC2, DISP1, DISP2, CALC3, CALC4) enthält, die über wenigstens eine Kommunikationsverbindung (LIA, BUS) verbunden sind, in dem
der Test vorbereitet wird, indem:
- eine formale Testprozedur (ATP, Test_Procedure) vorbereitet wird, die über eine oder mehrere Verbindungen (Link) mit einer oder mit mehreren funktionalen Anforderungsspezifikationen (Functionnal_chain) für das System (SE) verbunden wird,
- eine Folge von Befehlen (Scenario_text_file) anhand dieser Testprozedur (ATP, Test_Procedure) automatisch erzeugt wird, was die Steuerung einer Testbank (BT) ermöglicht, die an das zu testende System (SE) angepasst und mit diesem verbunden ist, indem eine Datenbank (Interf DB) verwendet wird, die eine Definition aller Signale enthält, die durch die Geräte des Systems (SE) ausgetauscht werden können, und
- die funktionale Spezifikation (Functionnal_chain), die Folge von Befehlen (Scenario_text_file) sowie die eine oder die mehreren Verbindungen (Link) eingetragen werden;
woraufhin:
- das Testszenario (Scenario_text_file) in der Testbank ausgeführt wird, indem der Zustand des Systems (SE) in Bezug auf die in dem Testszenario angegebene Beschreibung kontrolliert und in einen Ausführungsbericht (Res_File) eingetragen wird, und
- die Ergebnisse des Ausführungsberichts automatisch in die Testprozedur (ATP, Test_Procedure, ATR) übertragen werden, wobei die Verbindung(en) ermöglicht (ermöglichen), die Gesamtheit von Anforderungen des Systems (SE), die durch Ausführen des Testszenarios getestet worden sind und die den erhaltenen Ergebnissen entsprechen, auf eindeutige Weise zu identifizieren.

11. Programm, das einen Code enthält, der in einem Träger fixiert ist oder durch ein Signal materialisiert ist, wobei der Code durch wenigstens eine Datenverarbeitungseinheit lesbar und/oder ausführbar ist, um die Funktion eines elektronischen Systems (SE) zu stimulieren und zu testen, wobei der Code Codesegmente enthält, um die Operationen eines Verfahrens nach einem der Ansprüche 1 bis 8 auszuführen.

12. System (SYST, BT) zum Testen eines elektronischen Systems (SE), das programmiert ist, um Operationen eines Verfahrens nach einem der Ansprüche 1 bis 8 auszuführen.
